# EUROPÄISCHE PATENTANMELDUNG

(11) **EP 2 985 555 A1**
(43) Veröffentlichungstag der Anmeldung: **17.02.2016**
(21) Anmeldenummer: 15180418.4
(22) Anmeldetag: 10.08.2015
(51) Int. Cl.: F28D 15/00

(54) **MONTAGEADAPTER FÜR HEATPIPES**

(30) Priorität: 10.08.2014 DE 202014006283 U
(71) Anmelder: Zamecki, Lutz, 12163 Berlin (DE)
(72) Erfinder: Zamecki, Lutz, 12163 Berlin (DE)
(74) Vertreter: Müller & Schubert

(57) **Zusammenfassung**

Die Erfindung beschreibt einen Montageadapter für eine Heatpipe, umfassend eine im Wesentlichen zylindrische Umhüllung, in welche eine Heatpipe einführbar ist,
wobei die im Wesentlichen zylindrische Umhüllung eine Öffnung in Längsrichtung in der Zylinderwand aufweist,
so dass ein Teil der Mantelfläche der darin eingelegten Heatpipe nicht von der Umhüllung umschlossen ist und dabei aus der Umhüllung herausragt, und
wobei die im Wesentlichen zylindrische Umhüllung weiterhin zwei von der Umhüllung auswärts weisende flächige Materialstreifen aufweist, welche derart an der im Wesentlichen zylindrischen Umhüllung angebracht sind, dass die Unterseiten der flächigen Materialstreifen mit der Öffnung in Längsrichtung in der Zylinderwand eine Ebene ausbilden.

## Beschreibung

Die vorliegende Erfindung betrifft einen Montageadapter für Heatpipes.

Die Heatpipe ist ein Kupferrohr mit einer internen Struktur die ein Fließen von flüssigen Medien unterstützt, auch entgegen der Gravitation.

Die hier zur Anwendung kommenden 8 mm Heatpipes bestehen aus einem Kupferrohr mit einer Wanddicke von 0.4 mm ± 0.02 mm und einer inneren Struktur (Wickstruktur), die einen Rückfluss des flüssigen Mediums unterstützt.

Heatpipes werden verwendet um Wärme von Hotspots zu einem Kühlelement zu transportieren. Dafür ist eine mechanische Befestigung der Heatpipe auf/an der Wärmequelle und am Kühlelement notwendig. Um bei der Montage entstehende thermische Widerstande so gering wie möglich zu halten ist ein Kraft- und Formschluss zwischen Montageelement, Heatpipe und Kühlelement notwendig. Dies gilt auch für die Montage an der Wärmequelle.

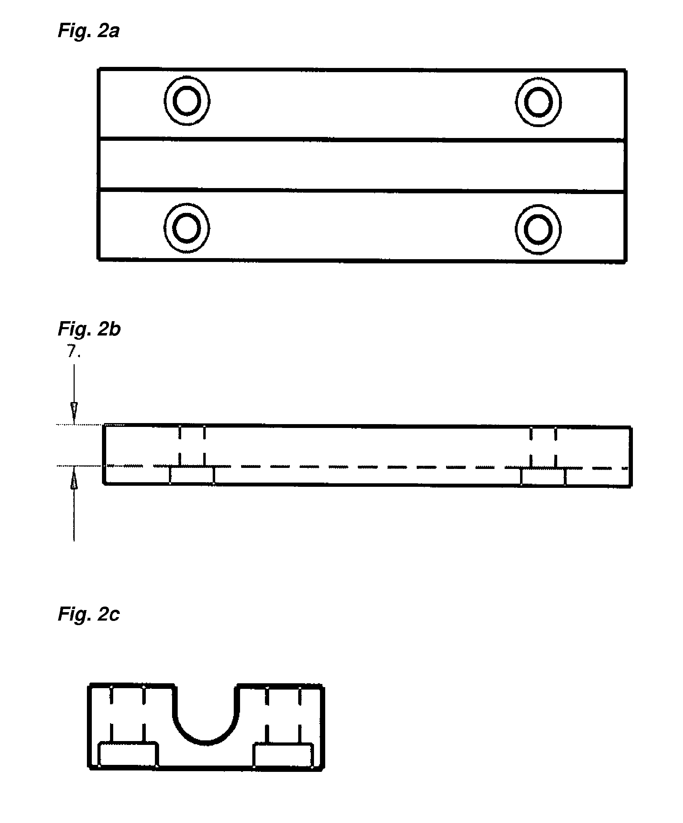

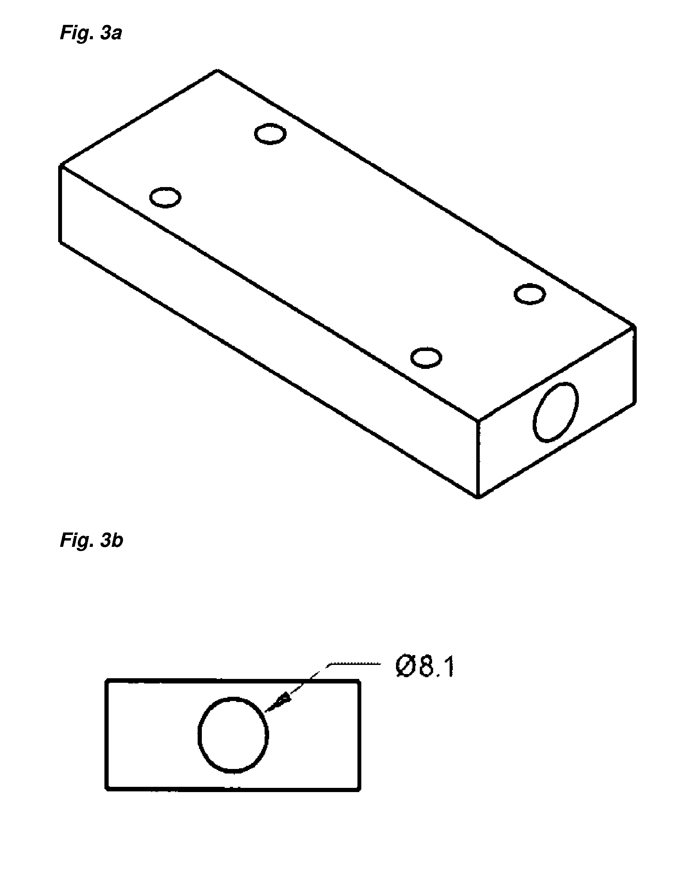

Derzeit werden Montageadapter verwendet, die entweder eine Bohrung haben, in die die Heatpipe gesteckt wird oder eine Nut aufweisen, in die die Heatpipe eingelegt wird. Bei der Version mit einem Loch/Bohrung - siehe Fig. 3a und Fig. 3b - besteht das Problem, dass die Heatpipe nie einen Kraft und Formschluss mit dem Montageelement und Kühlelement hat. Daraus resultieren schlechte thermische Eigenschaften der Lösung. Bei der Version mit einer Nut - siehe Fig. 2a und Fig. 2b - wird entsprechend dem Durchmesser der Heatpipe eine Nut im Montageadapter verwendet. Die Tiefe der Nut wird geringer ausgeführt als der Durchmesser der Heatpipe ist. Dadurch wird die Heatpipe zwischen Montageelement und Kühlelement gequetscht. Es entsteht ein Kraft- und Formschluss zwischen den drei Teilen. Dabei wird die Heatpipe deformiert, was zu einer Beschädigung der Wickstruktur führen kann. An der Stelle, wo die Wickstruktur beschädigt wurde hat diese dann keinen Kontakt mehr mit dem Kupferrohr. An dieser Stelle wird der Rückfluss des flüssigen Mediums blockiert. Dies führt zu einem Transportverlust von 25% und mehr des normalerweise möglichen Flüssigkeitstransportes.

In wieweit die Heatpipe bei der Montage intern beschädigt wurde kann nur durch einen 100% Funktionstest nachgewiesen werden. Leichte Beschädigungen der Wickstruktur, die bei diesem Test auf Grund von Toleranzen nicht gefunden wurden, können zu späteren Ausfällen führen.

In der US 2011/0114293 A1 wird eine weitere Lösung zur Befestigung von Heatpipes offenbart, welche der oben beschriebenen Version mit einer Nut gemäß der Fig. 2 nahe kommt. Allerdings wird auch hierbei keine formschlüssige Verbindung mit den Heatpipes vorgeschlagen.

Aufgabe der vorliegenden Erfindung ist es daher, einen Montageadapter zur Verfügung zu stellen, welcher die Nachteile des Standes der Technik überwindet und eine kraft- und formschlüssige Verbindung zwischen den Montagelementen zu bewirken.

Es sollte eine Lösung gefunden werden, bei der der Kraft- und Formschluss erhalten bleibt und trotzdem die Wickstruktur der Heatpipe bei der Montage nicht beschädigt wird. Der Ansatz war, die Heatpipe über mehr als nur die Hälfte des Umfanges mechanisch so zu führen, dass durch die Montage der Heatpipe an das Kühlelement eine optimale thermische Anbindung realisiert werden kann.

Die Aufgabe wird durch einen Montageadapter für Heatpipes mit den Merkmalen des Hauptanspruchs gelöst. Vorteilhafte Weiterbildungen des erfindungsgemäßen Adapters für Heatpipes werden n den abhängigen Unteransprüchen gekennzeichnet.

Gegenstand der Erfindung ist ein Montageadapter für eine Heatpipe, umfassend eine im Wesentlichen zylindrische Umhüllung, in welche eine Heatpipe einführbar ist,
wobei die im Wesentlichen zylindrische Umhüllung eine Öffnung in Längsrichtung in der Zylinderwand aufweist,
so dass ein Teil der Mantelfläche der darin eingelegten Heatpipe nicht von der Umhüllung umschlossen ist und dabei aus der Umhüllung herausragt, und
wobei die im Wesentlichen zylindrische Umhüllung weiterhin zwei von der Umhüllung auswärts weisende flächige Materialstreifen aufweist, welche derart an der im Wesentlichen zylindrischen Umhüllung angebracht sind, dass die Unterseiten der flächigen Materialstreifen mit der Öffnung in Längsrichtung in der Zylinderwand eine Ebene ausbilden.

Erfindungsgemäß bevorzugt ist dabei, dass der Querschnitt des Montageadapters im Wesentlichen die Form des Großbuchstaben Omega aufweist.

Erfindungsgemäß ist außerdem bevorzugt, dass ein Teil der Mantelfläche der in den Adapter eingeführten Heatpipe aus der Fläche, welche durch die Unterseiten der flächigen Materialstreifen und der Öffnung in Längsrichtung in der Zylinderwand ausgebildet ist, herausragt.

Weiterhin ist ebenfalls bevorzugt, dass die Unterseiten der flächigen Materialstreifen für die Montage auf einem Kühlelement vorgesehen sind.

Ganz besonders ist erfindungsgemäß bevorzugt, dass die Öffnung der im Wesentlichen zylindrischen Umhüllung einen Öffnungswinkel von 45° aufweist.

Ganz besonders ist erfindungsgemäß ebenfalls bevorzugt, dass die im Wesentlichen zylindrische Umhüllung einen Innendurchmesser von 8,1 mm aufweist.

Die vorliegende Erfindung wird mit den beigefügten Zeichnungen näher erläutert. Es zeigt:
Fig. 1a eine perspektivische Ansicht eines erfindungsgemäßen Montageadapters;
Fig. 1b einen Querschnitt durch den erfindungsgemäßen Montageadapter gemäß Fig. 1a;
Fig. 2a eine Aufsicht auf einen Montageadapter gemäß dem Stand der Technik;
Fig. 2b einen Längsschnitt des Montageadapters gemäß Fig. 2a;
Fig. 2c einen Querschnitt des Montageadapters gemäß Fig. 2a
Fig. 3a eine Aufsicht auf einen weiteren Montageadapter gemäß dem Stand der Technik; und
Fig. 3b einen Querschnitt des Montageadapters gemäß Fig. 3a.

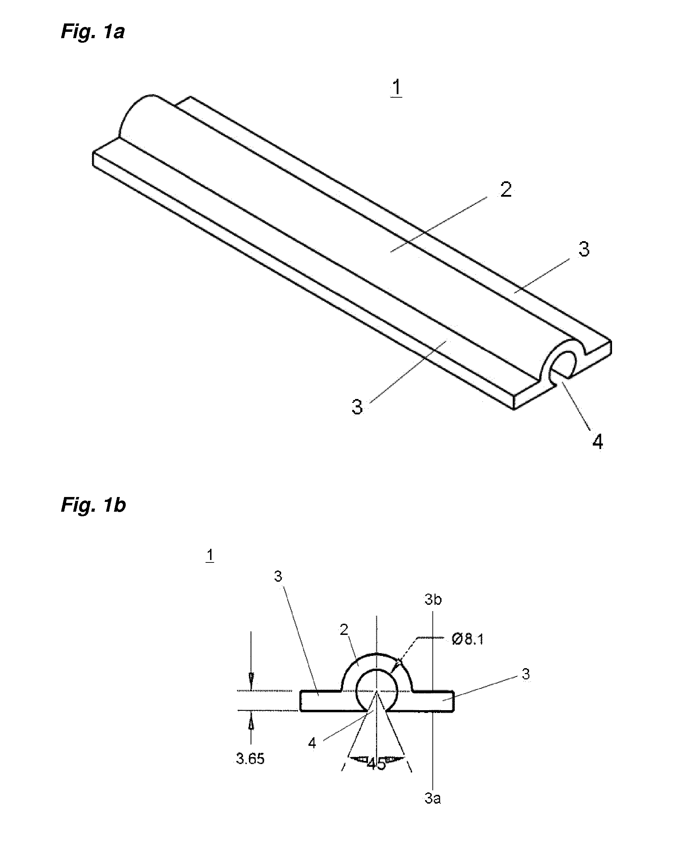

In der Fig. 1a ist eine Ausführungsform des erfindungsgemäßen Montageadapters für Heatpipes 1 dargestellt. Der Adapter 1 besteht aus einer Umhüllung 2. Diese Umhüllung 2 ist ein im Wesentlichen zylindrischer Körper, welcher derart ausgestaltet ist, um im Inneren des zylindrischen Körpers eine Heatpipe (nicht dargestellt) aufzunehmen. Die Umhüllung ist nun weiterhin mit einer Öffnung 4 versehen, welche sich in Längsrichtung der Zylinderwand der Umhüllung 2 erstreckt. Diese Öffnung 4 weist eine derartig geringe Weite auf, so dass die Heatpipe nicht durch die Öffnung 4 in die Umhüllung 2 eingeführt werden kann. Vielmehr ist vorgesehen, die Heatpipe durch das Lichtmaß des Zylinders einzuführen. Hat man eine Heatpipe in die Umhüllung eingeführt, so ragt ein Teil der Mantelfläche der Heatpipe aus der Öffnung 4 heraus.

Weiterhin ist der Längsrichtung der Umhüllung 2, also des im Wesentlichen zylindrischen Körpers, zwei Materialstreifen 3 vorgesehen. Diese Materialstreifen 3 weisen eine jeweils eine Unterseite 3a und eine Oberseite 3b auf. Diese Materialstreifen 3 weisen von der Umhüllung 2 weg und sind somit nach auswärts gerichtet. Die Materialstreifen 3 sind derart an der Umhüllung angebracht, dass die Unterseiten 3a der Materialstreifen 3 zusammen mit der Öffnung 4 des zylindrischen Körpers der Umhüllung 2 eine Ebene ausbilden. Die Ausbildung dieser ebenen Fläche ist erforderlich und vorteilhaft, weil dadurch die Anordnung des Montageadapters auf den entsprechenden zu kühlenden Komponenten erfolgen kann. Hierzu kann es vorteilhaft sein, dass in den Materialstreifen 3 Bohrungen (nicht dargestellt) vorgesehen sind, mittels welcher der Montageadapter an den Komponenten befestigt werden kann. Selbstverständlich kann die Montage auch durch Kleben erfolgen, wobei entsprechende wärmeleitende Kleber (Wärmeleitkleber) verwendet werden.

In der Fig. 1b ist ein Querschnitt durch eine Ausführungsform eines erfindungsgemäßen Montageadapters gemäß der Fig. 1a gezeigt. Hier wird nochmals im Detail dargestellt, dass die Öffnung 4 und die Unterseiten 3a der Materialstreifen eine Ebene ausbilden. Diese Ebene wird dann mit dem Kühlkörper oder einer anderen Komponente, von der oder zu welcher Wärme abgeleitet oder zugeführt werden soll, fest verbunden. Dadurch wird die in die Umhüllung eingeführte Heatpipe (nicht dargestellt) gequetscht bzw. abgeflacht und weist daher eine größere Kontaktfläche zu dem Kühlkörper etc. auf. Wegen der form- und kraftschlüssigen Verbindung zwischen Umhüllung 2 und der Heatpipe sowie der Oberfläche des Kühlkörpers etc. wird eine optimale Wärmeübertragung erzielt.

In der Fig. 1b sind ferner die besonders vorteilhaften und bevorzugten Baumaße des erfindungsgemäßen Montageadapters angegeben. Wegen des Durchmessers von 8 mm für die Heatpipes ist ein Innendurchmesser von 8,1 mm besonders vorteilhaft. Auch der Öffnungswinkel der Öffnung 4 von 45 °ist besonders vorteilhaft.

In der Fig. 1b ist auch die Ausgestaltung des Querschnitts des Montageadapters 1 in Form des Großbuchstaben Omega zu erkennen. Diese Form des Adapters weist den Vorteil auf, dass die Montage des Adapters in einfacher Weise erfolgen kann. Wird die Heatpipe in den Adapter eingeführt, so kann dieser nicht von der Heatpipe abrutschen. Dies ist bei der von Hand durchgeführten Montage und insbesondere Justierung der beiden Heatpipeenden an den jeweiligen Montageposition von großem Vorteil. Bei einem Adaptersystem mit einer Nut gemäß Fig. 2 muss stets auch der Adapter von Hand gehalten werden, was die Montage erschwert, da zusätzliche Haltevorrichtungen während der Montage benötigt werden.

Aus der Fig. 1a wird auch ersichtlich, dass der Materialverbrauch wesentlich geringer ist. Im Vergleich zum Adapter nach dem Stand der Technik gemäß Fig. 2 wird deutliche, dass die im Querschnitt gezeigte Materialmenge beim erfindungsgemäßen Adapter wesentlich geringer ist.

Es ist klar, dass der erfindungsgemäße Montageadapter aus jedem geeignetem Material hergestellt werden kann. Geeignet sind Materialien, welche eine ausreichende Wärmeleitfähigkeit besitzen. Bevorzugte Materialien sind ausgewählt aus Aluminium, Aluminiumlegierungen, Kupfer, Kupferlegierungen, Bronzen und Stählen.

Die Herstellung des erfindungsgemäßen Montageadapters ist in einfacher Weise möglich. Dies kann durch Schmelzextrusion einer geeigneten Aluminiumlegierung erfolgen. Der Extrusionsstrang wird dann abgelängt und ggf. mit den entsprechenden Bohrungen zur Befestigung versehen. Dabei können Fertigungstoleranzen für den Innendurchmesser von 8,1 mm ± 0,15 mm in einfacher Weise eingehalten werden. Dies gewährleistet, dass auch bei Berücksichtigung der üblichen Fertigungstoleranzen für die Heatpipes von 8 mm ± 0,05 mm stets eine form- und kraftschlüssige Verbindung zwischen Adapter und Heatpipe gewährleistet ist.

Der erfindungsgemäße Heatpipe-Montageadapter gemäß Fig. 1a und Fig. 1 b ist derart geformt, dass von den 360° des Umfanges eines Heatpipe-Rohres ca. 87,5% mechanischen Kontakt mit dem Montageadapter haben. 12,5% des Umfanges der Heatpipe haben einen direkten Kontakt zum Kühlelement. Der offene Bereich hat einen Winkel von ca. 45° des vollen Umfanges der Heatpipe. Das Montageadapter umschließt die Heatpipe über 315° des Umfanges. Durch diese Art des Montageadapters ragen ca. 0,3 mm des Heatpipe Durchmessers aus dem Montageadapter in Richtung zum Kühlelement aus dem Adapter heraus. Diese 0,3 mm gewährleisten einen Kraft- und Formschluss zwischen Montageadapter, Heatpipe und Kühlelement.

Es ist klar, dass die hierin angegebenen Maße für den erfindungsgemäßen Adapter nur beispielhaft zu verstehen sind. Natürlich kann der erfindungsgemäße Adapter auch in der Größe derart gestaltet werden, dass Heatpipes mit größerem oder auch kleinerem Durchmesser aufgenommen werden können.

Es wurden thermische Messreihen durchgeführt, bei denen sowohl der im Stand der Technik bekannte Montageadapter mit einer Nut (Fig. 2) wie auch der erfindungsgemäße Montageadapter (Fig. 1a, 1b) zum Einsatz kamen. Das Ergebnis war, dass keinerlei Beschädigung der Heatpipe feststellbar war und dass eine um 1°K bessere thermische Eigenschaft des erfindungsgemäßen Adapters nachweisbar war. Die Vorteile des erfindungsgemäßen Montageadapters sind geringerer Materialbedarf, geringeres Gewicht und geringere Kosten bei der Herstellung.

### Bezugszeichenliste

- 1: Montageadapter
- 2: Umhüllung
- 3: Materialstreifen
- 3a: Unterseite des Materialstreifens
- 3b: Oberseite des Materialstreifens
- 4: Öffnung

## Patentansprüche

1. Montageadapter für eine Heatpipe, umfassend eine im Wesentlichen zylindrische Umhüllung, in welche eine Heatpipe einführbar ist,
wobei die im Wesentlichen zylindrische Umhüllung eine Öffnung in Längsrichtung in der Zylinderwand aufweist,
so dass ein Teil der Mantelfläche der darin eingelegten Heatpipe nicht von der Umhüllung umschlossen ist und dabei aus der Umhüllung herausragt, und
wobei die im Wesentlichen zylindrische Umhüllung weiterhin zwei von der Umhüllung auswärts weisende flächige Materialstreifen aufweist, welche derart an der im Wesentlichen zylindrischen Umhüllung angebracht sind,
dass die Unterseiten der flächigen Materialstreifen mit der Öffnung in Längsrichtung in der Zylinderwand eine Ebene ausbilden.

2. Montageadapter, nach Anspruch 1, **dadurch gekennzeichnet, dass** der Querschnitt des Montageadapters im Wesentlichen die Form des Großbuchstaben Omega aufweist.

3. Montageadapter, nach Anspruch 1 oder 2, **dadurch gekennzeichnet, dass** ein Teil der Mantelfläche der in den Adapter eingeführten Heatpipe aus der Fläche, welche durch die Unterseiten der flächigen Materialstreifen und der Öffnung in Längsrichtung in der Zylinderwand ausgebildet ist, herausragt.

4. Montageadapter, nach einem der voranstehenden Ansprüche, **dadurch gekennzeichnet, dass** die Unterseiten der flächigen Materialstreifen für die Montage auf einem Kühlelement vorgesehen sind.

5. Montageadapter, nach einem der voranstehenden Ansprüche, **dadurch gekennzeichnet, dass** die Öffnung der im Wesentlichen zylindrischen Umhüllung einen Öffnungswinkel von 45° aufweist.

6. Montageadapter, nach einem der voranstehenden Ansprüche, **dadurch gekennzeichnet, dass** die im Wesentlichen zylindrische Umhüllung einen Innendurchmesser von 8,1 mm aufweist.
